# EUROPEAN PATENT SPECIFICATION

(11) **EP 3 628 713 B1**
(45) Date of publication and mention of the grant of the patent: **12.01.2022**
(21) Application number: 19199915.0
(22) Date of filing: 26.09.2019
(51) Int. Cl.: C09G 1/00

(54) **HIGH OXIDE VS NITRIDE SELECTIVITY, LOW AND UNIFORM OXIDE TRENCH DISHING IN SHALLOW TRENCH ISOLATION (STI) CHEMICAL MECHANICAL PLANARIZATION POLISHING (CMP)**
HOCHOXID- VS NITRIDSELEKTIVITÄT, TRENCH-DISHING MIT NIEDRIGEM UND GLEICHMÄSSIGEM OXIDGEHALT BEIM CHEMISCH-MECHANISCHEN POLIEREN UND PLANARISIEREN MIT FLACHGRABENISOLATION (STI)
SÉLECTIVITÉ ÉLEVÉE À L'OXYDE PAR RAPPORT AU NITRURE, PLATS DANS UNE TRANCHÉE À DEGRÉ D'OXYDATION FAIBLE ET UNIFORME LORS DU POLISSAGE DE PLANARISATION MÉCANIQUE ET CHIMIQUE (CMP) DE L'ISOLATION DE TRANCHÉE PEU PROFONDE (STI)

(30) Priority: 26.09.2018 US 201862736963 P; 20.09.2019 US 201916577358
(43) Date of publication of application: 01.04.2020
(73) Proprietor: Versum Materials US, LLC, Tempe, AZ 85284 (US)
(72) Inventor: SHI, Xiaobo, Tempe, Arizona 85284 (US); ROSE, Joseph D, Tempe, Arizona 85284 (US); MURELLA, Krishna P., Tempe, Arizona 85284 (US); ZHOU, Hongjun, Tempe, Arizona 85284 (US); O'NEILL, Mark Leonard, Tempe, Arizona 85284 (US)
(74) Representative: Beck Greener LLP

(56) References cited:
- EP-A1- 0 846 740

## Description

### BACKGROUND OF THE INVENTION

This invention relates to the STI CMP chemical polishing compositions and chemical mechanical planarization (CMP) for Shallow Trench Isolation (STI) process.

In the fabrication of microelectronics devices, an important step involved is polishing, especially surfaces for chemical-mechanical polishing for the purpose of recovering a selected material and/or planarizing the structure.

For example, a SiN layer is deposited under a SiO₂ layer to serve as a polish stop. The role of such polish stop is particularly important in Shallow Trench Isolation (STI) structures. Selectivity is characteristically expressed as the ratio of the oxide polish rate to the nitride polish rate. An example is an increased polishing selectivity rate of silicon dioxide(SiO₂) as compared to silicon nitride(SiN).

In the global planarization of patterned STI structures, reducing oxide trench dishing is a key factor to be considered. The lower trench oxide loss will prevent electrical current leaking between adjacent transistors. Non-uniform trench oxide loss across die (within Die) will affect transistor performance and device fabrication yields. Severe trench oxide loss (high oxide trench dishing) will cause poor isolation of transistor resulting in device failure. Therefore, it is important to reduce trench oxide loss by reducing oxide trench dishing in STI CMP polishing compositions.

US Patent 5,876,490 discloses the polishing compositions containing abrasive particles and exhibiting normal stress effects. The slurry further contains non-polishing particles resulting in reduced polishing rate at recesses, while the abrasive particles maintain high polish rates at elevations. This leads to improved planarization. More specifically, the slurry comprises cerium oxide particles and polymeric electrolyte, and can be used for Shallow Trench Isolation (STI) polishing applications.

US Patent 6,964,923 teaches the polishing compositions containing cerium oxide particles and polymeric electrolyte for Shallow Trench Isolation (STI) polishing applications. Polymeric electrolyte being used includes the salts of polyacrylic acid, similar as those in US Patent 5,876,490. Ceria, alumina, silica & zirconia are used as abrasives. Molecular weight for such listed polyelectrolyte is from 300 to 20,000, but in overall, <100,000.

US Patent 6,616,514 disclosed a chemical mechanical polishing slurry for use in removing a first substance from a surface of an article in preference to silicon nitride by chemical mechanical polishing. The chemical mechanical polishing slurry according to the invention includes an abrasive, an aqueous medium, and an organic polyol that does not dissociate protons, said organic polyol including a compound having at least three hydroxyl groups that are not dissociable in the aqueous medium, or a polymer formed from at least one monomer having at least three hydroxyl groups that are not dissociable in the aqueous medium.

US Patent 5,738,800 disclosed a composition for polishing a composite comprised of silica and silicon nitride comprising: an aqueous medium, abrasive particles, a surfactant, and a compound which complexes with the silica and silicon nitride wherein the complexing agent has two or more functional groups each having a dissociable proton, the functional groups being the same or different.

WO Patent 2007/086665A1 disclosed a CMP slurry in which a compound having a weight-average molecular weight of 30-500 and containing a hydroxyl group (OH), a carboxyl group (COOH), or both, is added to a CMP slurry comprising abrasive particles and water and having a first viscosity, so that the CMP slurry is controlled to have a second viscosity 5-30% lower than the first viscosity. Also disclosed is a method for polishing a semiconductor wafer using the CMP slurry. According to the disclosed invention, the agglomerated particle size of abrasive particles in the CMP slurry can be reduced, while the viscosity of the CMP slurry can be reduced and the global planarity of wafers upon polishing can be improved. Thus, the CMP slurry can be advantageously used in processes for manufacturing semiconductor devices requiring fine patterns and can improve the reliability and production of semiconductor devices through the use thereof in semiconductor processes.

However, those prior disclosed Shallow Trench Isolation (STI) polishing compositions did not address the importance of oxide trench dishing reducing and more uniform oxide trench dishing on the polished patterned wafers along with the high oxide vs nitride selectivity.

EP Patent EP0846740A1 discloses CMP compositions comprising abrasive particles and additives such as poly-acids or poly-bases for reducing the polishing rate of trenches. Ceria particles are one of the various types of abrasive particle that are disclosed. The types of disclosed poly-acids include those having multiple carboxylic acid groups, such as polyacrylic acid, polymethacrylic acid and polyacrylic acid-co-maleic acid. The polishing compositions are preferably alkaline, having a pH of 9 to 11.

It should be readily apparent from the foregoing that there remains a need within the art for compositions, methods and systems of STI chemical mechanical polishing that can afford the reduced oxide trench dishing and more uniformed oxide trench dishing across various sized oxide trench features on polishing patterned wafers in a STI chemical and mechanical polishing (CMP) process, in addition to high removal rate of silicon dioxide as well as high selectivity for silicon dioxide to silicon nitride.

### BRIEF SUMMARY OF THE INVENTION

The present invention provides for a reduced oxide trench dishing and more uniformed oxide trench dishing across various sized oxide trench features on the polished patterned wafers as well as provides high oxide vs nitride selectivity by introducing chemical additives as SiN film removal rate suppressing agents and oxide trenching dishing reducers in the Chemical mechanical polishing (CMP) compositions for Shallow Trench Isolation (STI) CMP applications at wide pH range including acidic, neutral and alkaline pH conditions.

The disclosed chemical mechanical polishing (CMP) composition for Shallow Trench Isolation (STI) CMP applications have a unique combination of using ceria-coated inorganic oxide particles as abrasives and the suitable chemical additives as oxide trench dishing reducing agents and nitride removal rate suppressing agents.

In one aspect, there is provided a STI CMP polishing composition that comprises:
ceria-coated inorganic oxide particles;
0.0006 wt.% to 0.25 wt. % of a chemical additive comprising at least one carboxylic acid group (R-COOH), at least one carboxylate salt group(s) or at least one carboxylic ester group; and at least two hydroxyl functional groups (OH) in the same molecule;
a water-soluble solvent; and
optionally biocide; and
optionally pH adjuster;
wherein the composition has a pH of 4 to 9, and most preferably 4.5 to 7.5.

The ceria-coated inorganic oxide particles include, but are not limited to, ceria-coated colloidal silica, ceria-coated high purity colloidal silica, ceria-coated alumina, ceria-coated titania, ceria-coated zirconia and combinations thereof.

The water-soluble solvent includes but is not limited to deionized (DI) water, distilled water, and alcoholic organic solvents.

The chemical additive functions as a SiN film removal rate suppressing agent and oxide trenching dishing reducer.

Some of these chemical additives have a general molecular structure as shown below: 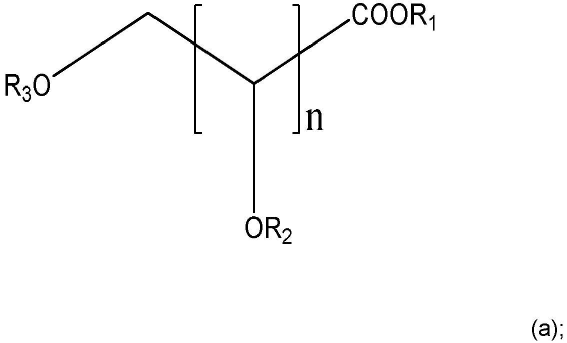 or

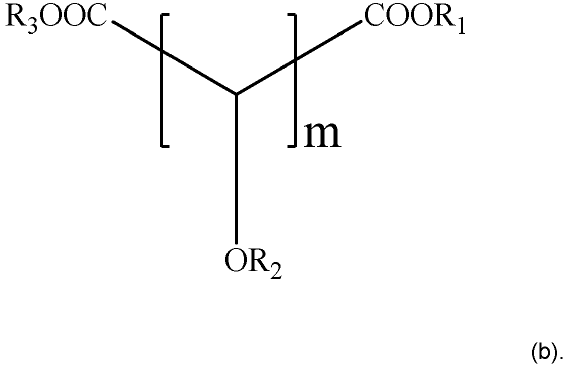

In the general molecular structure (a) or (b), n is selected from 1 to 5,000, the preferred n is from 2 to 12, the more preferred n is from 3 to 6, m is selected from 2 to 5,000, the preferred m is from 2 to 12.

R1, R2, and R3 can be the same or different atoms or functional groups. They can be independently selected from the group consisting of hydrogen, alkyl, alkoxy, organic group with one or more hydroxyl groups, substituted organic sulfonic acid, substituted organic sulfonic acid salt, substituted organic carboxylic acid, substituted organic carboxylic acid salt, organic carboxylic ester, organic amine groups, and combinations thereof; wherein, at least two or more, preferably three or more are hydrogen atoms.

In addition, R1, R3, or both R1 and R3 can also be a metal ion or ammonium ion. The metal ion includes but is not limited to sodium ion, potassium ion.

When R1, R2, and R3 are all hydrogen atoms, the chemical additive bears one (structure (a)) or two (structure (b)) organic carboxylic acid groups and two or more hydroxyl functional groups.

The molecular structures of some examples of suitable chemical additives are listed below: 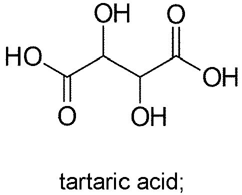 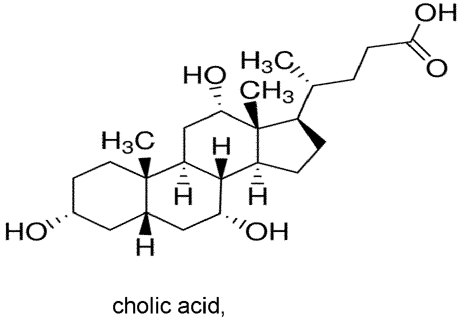 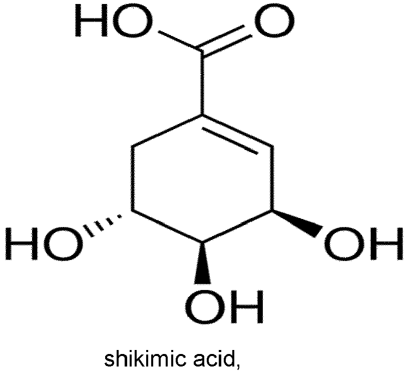 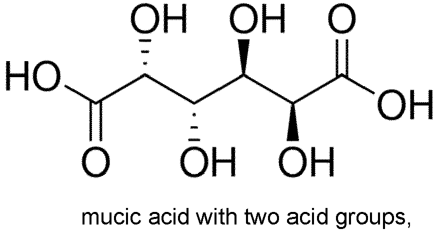 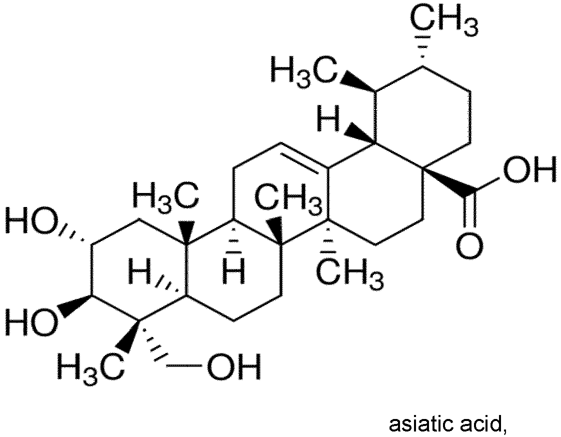 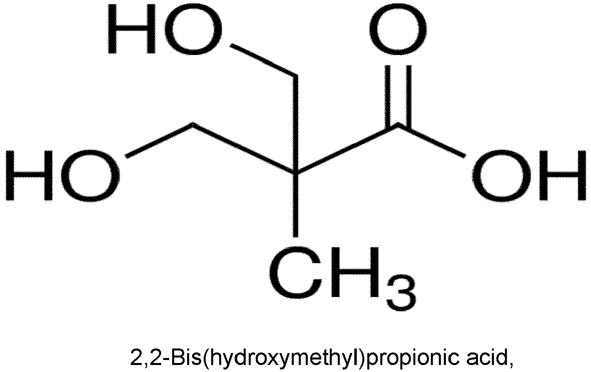 and

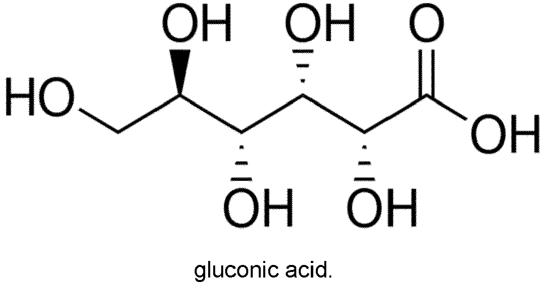

When R1 is a metal ion or ammonium ion in structure (a), the chemical additives have general molecular structures as listed below: 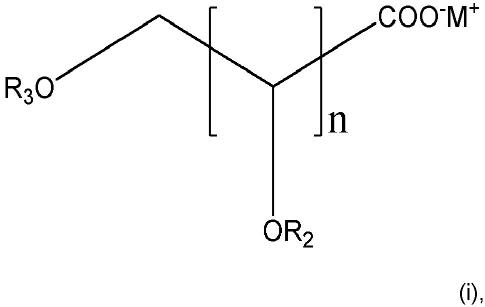 or

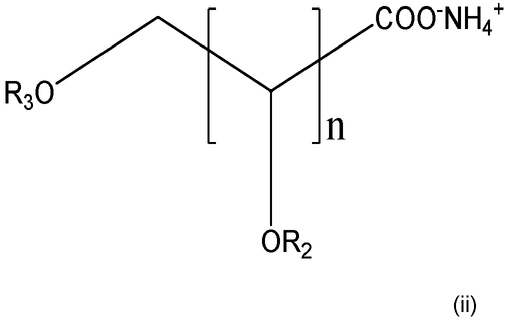

When R1 and R3 are both metal ions or ammonium ions in structure (b), the chemical additives have general molecular structures as listed below: 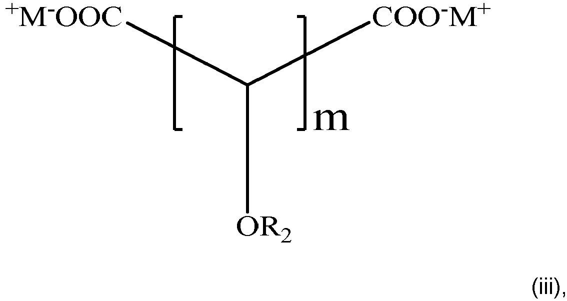 or

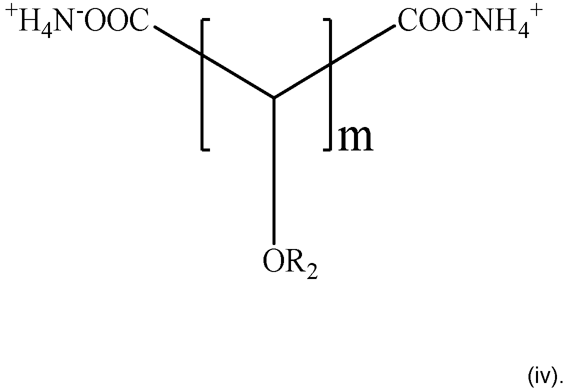

When R 1 is a metal ion and R2, and R3 are all hydrogen atoms in structure (i), the molecular structures of some examples of such chemical additives are listed below: 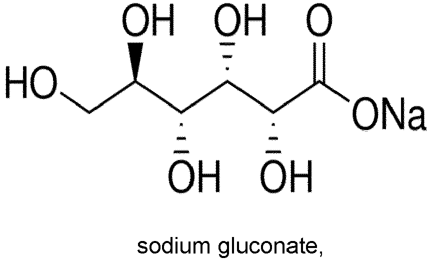 and

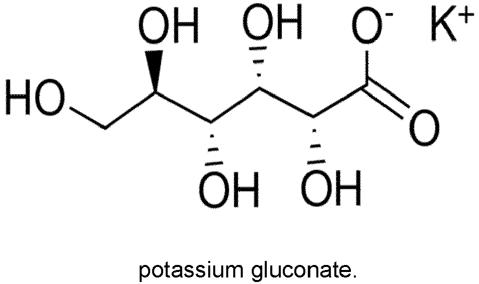

When R1 is an organic alkyl group in structure (a), the chemical additive has the organic acid ester functional group and bearing multi hydroxyl functional groups in the same molecule. The general molecular structure is shown below.

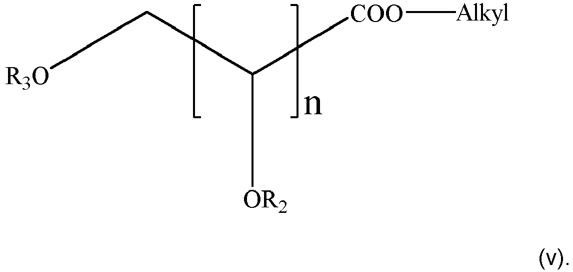

When R2, and R3 are hydrogen atoms in structure (v), the molecular structures of an examples of such chemical additive is shown below:

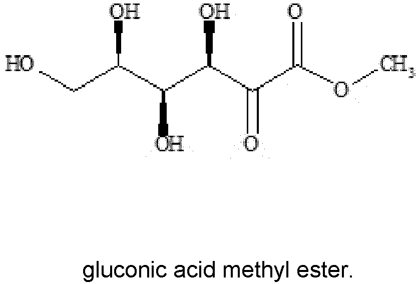

In another aspect, there is provided a method of chemical mechanical polishing (CMP) a substrate having at least one surface comprising silicon dioxide using the chemical mechanical polishing (CMP) composition described above in Shallow Trench Isolation (STI) process.

In another aspect, there is provided a system of chemical mechanical polishing (CMP) a substrate having at least one surface comprising silicon dioxide using the chemical mechanical polishing (CMP) composition described above in Shallow Trench Isolation (STI) process.

The polished oxide films can be Chemical vapor deposition (CVD), Plasma Enhance CVD (PECVD), High Density Deposition CVD(HDP), or spin on oxide films.

The substrate disclosed above can further comprises a silicon nitride surface. The removal selectivity of SiO₂: SiN is greater than silicon nitride is greater than 25, preferably greater than 30, and more preferably greater than 35.

### BRIEF DESCRIPTION OF SEVERAL VIEWS OF THE DRAWINGS

Figure 1. Effects of Gluconic Acid on Film RR (Å /min.) & TEOS: SiN Selectivity
Figure 2. Effects of Gluconic Acid on Oxide Trench Dishing Rate
Figure 3. Effects of Gluconic Acid on Oxide Trench Loss Rates (A/Sec.)
Figure 4. Effects of Gluconic Acid on Oxide Trench Dishing vs OP Times (Sec.)
Figure 5. Effects of Gluconic Acid on Oxide Trench Dishing vs OP Times (Sec.)
Figure 6. Effects of Gluconic Acid on Oxide Trench Dishing vs OP Times (Sec.)
Figure 7. Effects of different Gluconic Acid (GA) wt.% on Film RR (Å /min.) & TEOS: SiN Selectivity
Figure 8. Effects of different Gluconic Acid (GA) wt.% on Oxide Trench Dishing Rate
Figure 9. Effects of different Gluconic Acid(GA) wt.% on Oxide Trench Loss Rates (A/Sec.)
Figure 10. Effects of different Gluconic Acid wt.% on Oxide Trench Dishing vs OP Times (Sec.)
Figure 11. Effects of different Gluconic Acid wt.% on Oxide Trench Dishing vs OP Times (Sec.)
Figure 12. Effects of different Gluconic Acid wt.% on Oxide Trench Dishing vs OP Times (Sec.)
Figure 13. Effects of pH and 0.01 wt.% Gluconic Acid(GA) on Film RR (Å /min.) & TEOS: SiN Selectivity
Figure 14. Effects of pH with 0.01% Gluconic Acid (GA) on Oxide Trench Dishing Rate
Figure 15. Effects of pH with 0.01% Gluconic Acid(GA) on Oxide Trench Loss Rate
Figure 16. Effects of pH with 0.01% Gluconic Acid% on Oxide Trench Dishing vs OP Times (Sec.)
Figure 17. Effects of pH with 0.01% Gluconic Acid% on Oxide Trench Dishing vs OP Times (Sec.)
Figure 18. Effects of pH with 0.01% Gluconic Acid% on Oxide Trench Dishing vs OP Times (Sec.)

### DETAILED DESCRIPTION OF THE INVENTION

In the global planarization of patterned STI structures, suppressing SiN removal rates and reducing oxide trench dishing and providing more uniform oxide trench dishing across various sized oxide trench features are key factors to be considered. The lower trench oxide loss will prevent electrical current leaking between adjacent transistors. Non-uniform trench oxide loss across die (within Die) will affect transistor performance and device fabrication yields. Severe trench oxide loss (high oxide trench dishing) will cause poor isolation of transistor resulting in device failure. Therefore, it is important to reduce trench oxide loss by reducing oxide trench dishing in STI CMP polishing compositions.

This invention relates to the Chemical mechanical polishing(CMP) compositions for Shallow Trench Isolation (STI) CMP applications.

More specifically, the disclosed chemical mechanical polishing (CMP) composition for Shallow Trench Isolation (STI) CMP applications have a unique combination of using ceria-coated inorganic oxide abrasive particles and the suitable chemical additives as oxide trench dishing reducing agents and nitride suppressing agents.

The suitable chemical additives include, but are not limited to organic carboxylic acid molecules, organic carboxylate salts or organic carboxylic ester molecules bearing multi hydroxyl functional groups in the same molecules.

The chemical additives contain at least one organic carboxylic acid group, one carboxylate salt group or one carboxylic ester group and two or more hydroxyl functional groups in the same molecules.

The chemical additives provide the benefits of achieving high oxide film removal rates, low SiN film removal rates, high and tunable Oxide: SiN selectivity, and more importantly, significantly reducing oxide trench dishing and improving over polishing window stability on polishing patterned wafers.

In one aspect, there is provided a STI CMP polishing composition comprises:
ceria-coated inorganic oxide particles;
0.0006 wt.% to 0.25 wt. % of a chemical additive, comprising at least one organic carboxylic acid group(s), at least one carboxylate salt group, or at least one carboxylic ester group; and at least two hydroxyl functional groups in the same molecule, as SiN film removal rate suppressing agents and oxide trenching dishing reducers on polishing patterned wafers;
a water-soluble solvent; and
optionally biocide; and
optionally pH adjuster;
wherein the composition has a pH of 4 to 9, and preferably 4.5 to 7.5.

The ceria-coated inorganic oxide particles include, but are not limited to, ceria-coated colloidal silica, ceria-coated high purity colloidal silica, ceria-coated alumina, ceria-coated titania, ceria-coated zirconia, or any other ceria-coated inorganic metal oxide particles.

The particle sizes (measured by Dynamic Light Scattering DLS technology) of these ceria-coated inorganic oxide particles in the disclosed invention herein are ranged from 10nm to 1,000nm, the preferred mean particle sized are ranged from 20nm to 500nm, the more preferred mean particle sizes are ranged from 50nm to 250nm.

The concentrations of these ceria-coated inorganic oxide particles range from 0.01 wt.% to 20 wt.%, the preferred concentrations range from 0.05 wt.% to 10 wt.%, the more preferred concentrations range from 0.1 wt.% to 5 wt.%.

The preferred ceria-coated inorganic oxide particles are ceria-coated colloidal silica particles.

The preferred chemical additive as SiN film removal rate suppressing agents and oxide trenching dishing reducers comprise at least one carboxylic acid group (R-COOH), at least one carboxylate salt group(s) or at least one carboxylic ester group; and at least two hydroxyl functional groups (OH) in the same molecule;

Some of these chemical additives have a general molecular structure as shown below: 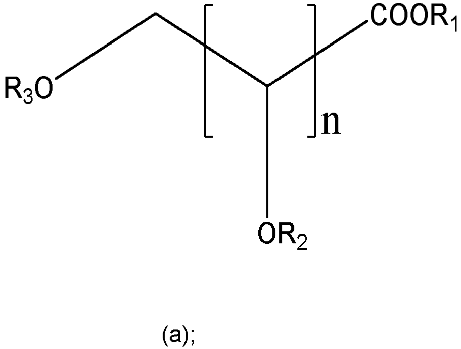 or

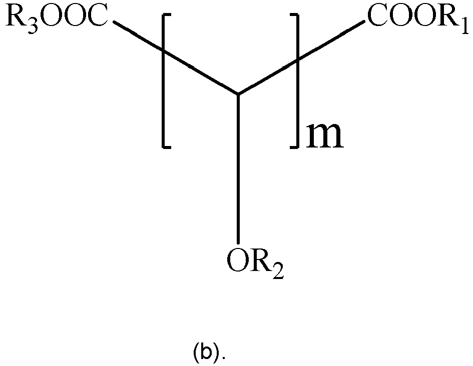

In the general molecular structure (a) or (b), n is selected from 1 to 5,000, the preferred n is from 2 to 12, the more preferred n is from 3 to 6, m is selected from 2 to 5,000, the preferred m is from 2 to 12.

R1, R2, and R3 can be the same or different atoms or functional groups. They can be independently selected from the group consisting of hydrogen, alkyl, alkoxy, organic group with one or more hydroxyl groups, substituted organic sulfonic acid, substituted organic sulfonic acid salt, substituted organic carboxylic acid, substituted organic carboxylic acid salt, organic carboxylic ester, organic amine groups, and combinations thereof; wherein, at least two or more, preferably three or more are hydrogen atoms.

In addition, R1, R3, or both R1 and R3 can also be a metal ion or ammonium ion. The metal ion includes but is not limited to sodium ion, potassium ion.

When R1, R2, and R3 are all hydrogen atoms, the chemical additive bears one (structure (a)) or two (structure (b)) organic carboxylic acid groups and two or more hydroxyl functional groups.

The molecular structures of some examples of suitable chemical additives are listed below: 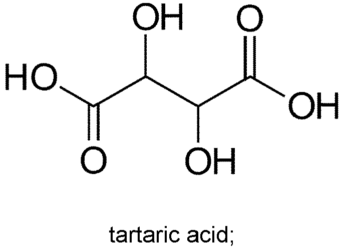 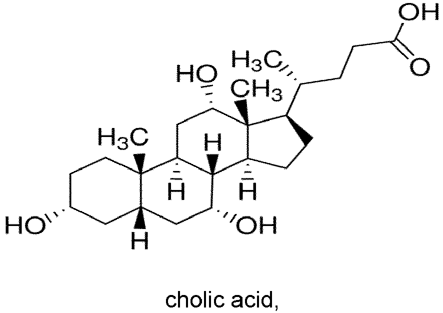 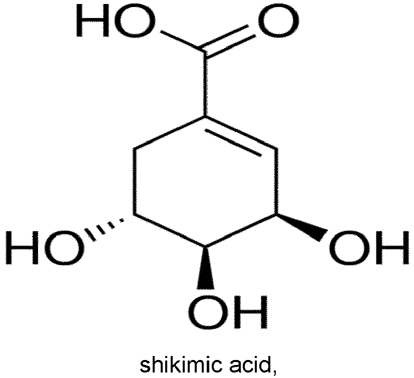 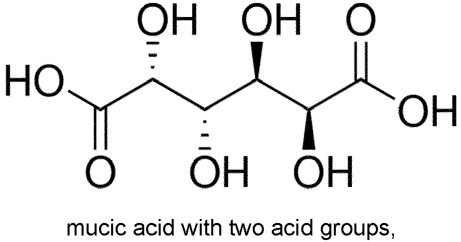 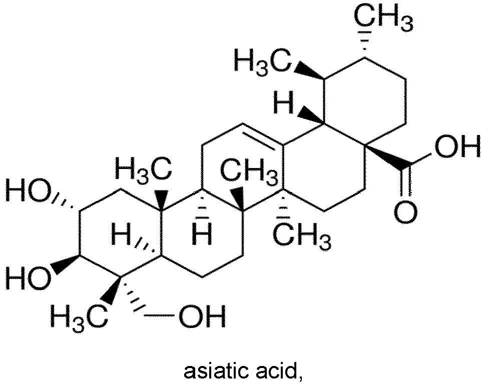 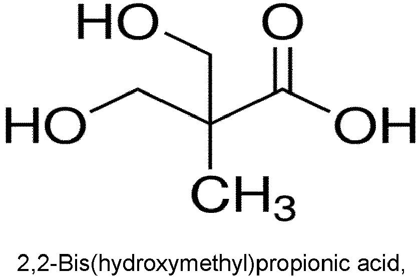 and

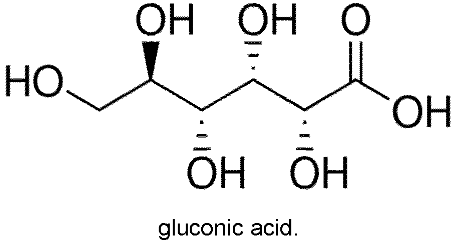

When R1 is a metal ion or ammonium ion in structure (a), the chemical additives have general molecular structures as listed below: 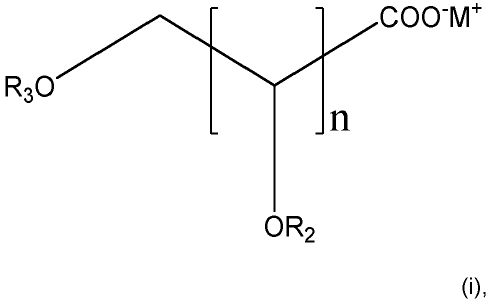 or

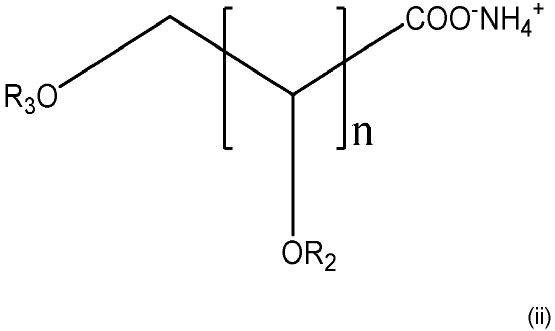

When R1 and R3 are both metal ions, or ammonium ions in structure (b), the chemical additives have general molecular structures as listed below: 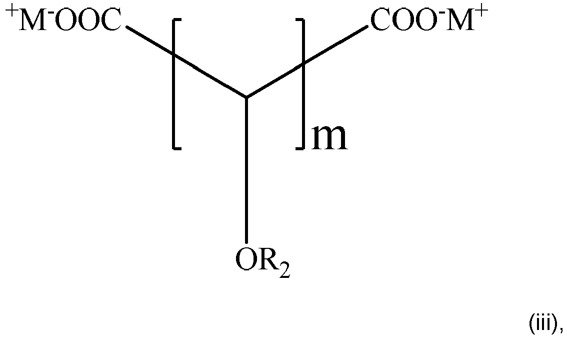 or

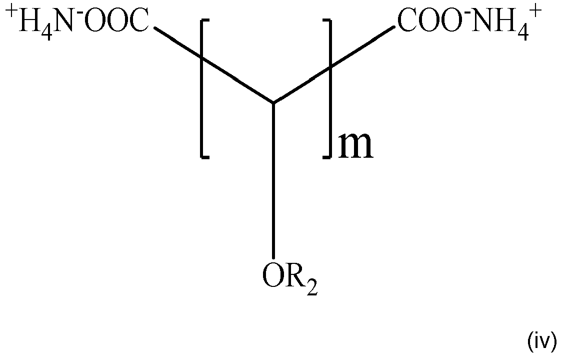

When R1 is a metal ion and R2, and R3 are all hydrogen atoms in structure (i), the molecular structures of some examples of such chemical additives are listed below: 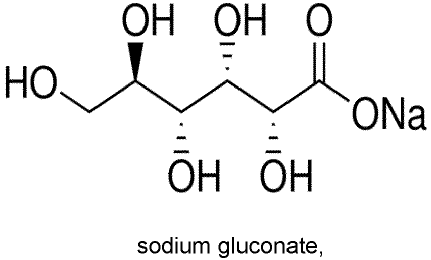 and

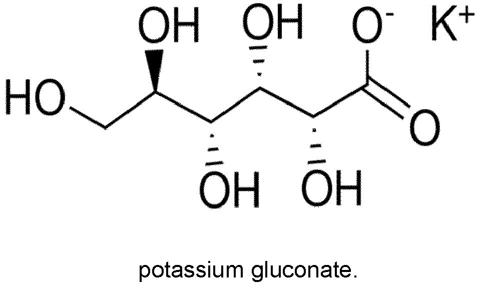

When R1 is an organic alkyl group in structure (a), the chemical additive has the organic acid ester functional group and bearing multi hydroxyl functional groups in the same molecule. The general molecular structure is shown below:

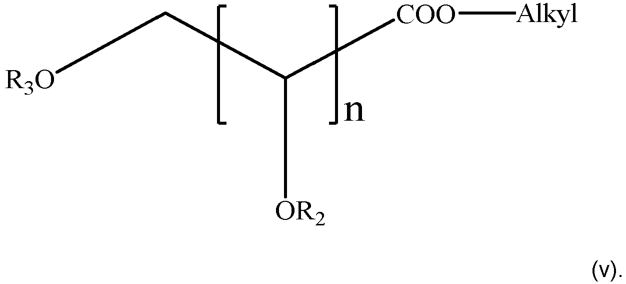

When R2, and R3 are hydrogen atoms in structure (v), the molecular structures of an examples of such chemical additive is shown below:

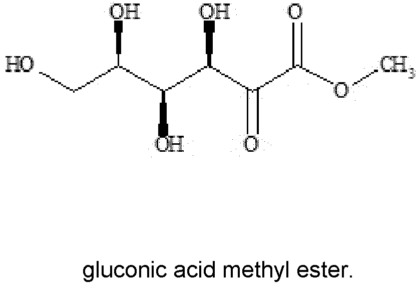

The STI CMP composition contains 0.0001 wt.% to 2.0% wt.%, 0.0002 wt.% to 1.0 wt.%, 0.0003 wt.% to 0.75 wt.%, 0.0004 wt.% to 0.5 wt.%, 0.0005 wt.% to 0.5 wt.%, 0.0006 wt.% to 0.25 wt. %, or 0.0007 wt.% to 0.1 wt. % chemical additives as SiN film removal rate suppressing agents and oxide trenching dishing reducers.

The water-soluble solvent includes but is not limited to deionized (DI) water, distilled water, and alcoholic organic solvents.

The preferred water-soluble solvent is DI water.

The STI CMP composition may contain biocide from 0.0001 wt.% to 0.05 wt.%; preferably from 0.0005 wt.% to 0.025 wt.%, and more preferably from 0.001 wt.% to 0.01 wt.%.

The biocide includes, but is not limited to, Kathon^{™}, Kathon^{™} CG/ICP II, from Dupont/Dow Chemical Co. Bioban from Dupont/Dow Chemical Co. They have active ingredients of 5-chloro-2-methyl-4-isothiazolin-3-one and 2-methyl-4-isothiazolin-3-one.

The STI CMP composition may contain a pH adjusting agent.

An acidic or basic pH adjusting agent can be used to adjust the STI polishing compositions to the optimized pH value.

The pH adjusting agents include, but are not limited to nitric acid, hydrochloric acid, sulfuric acid, phosphoric acid, other inorganic or organic acids, and mixtures thereof.

pH adjusting agents also include the basic pH adjusting agents, such as sodium hydride, potassium hydroxide, ammonium hydroxide, tetraalkyl ammonium hydroxide, organic quaternary ammonium hydroxide compounds, organic amines, and other chemical reagents that can be used to adjust pH towards the more alkaline direction.

The STI CMP composition contains 0 wt.% to 1 wt.%; preferably 0.01 wt.% to 0.5 wt.%; more preferably 0.1 wt.% to 0.25 wt.% pH adjusting agent.

The chemical additives used as SiN film removal rate suppressing agents and oxide trenching dishing reducers are organic carboxylic acid molecules, organic carboxylate salts or organic carboxylic ester molecules bearing multi hydroxyl functional groups in the same molecules.

In another aspect, there is provided a method of chemical mechanical polishing (CMP) a substrate having at least one surface comprising silicon dioxide using the chemical mechanical polishing (CMP) composition described above in Shallow Trench Isolation (STI) process.

In another aspect, there is provided a system of chemical mechanical polishing (CMP) a substrate having at least one surface comprising silicon dioxide using the chemical mechanical polishing (CMP) composition described above in Shallow Trench Isolation (STI) process.

The polished oxide films can be Chemical vapor deposition (CVD), Plasma Enhance CVD (PECVD), High Density Deposition CVD(HDP), or spin on oxide films.

The substrate disclosed above can further comprises a silicon nitride surface. The removal selectivity of SiO₂: SiN is greater than 25, preferably greater than 30, and more preferably greater than 35.

In another aspect, there is provided a method of chemical mechanical polishing (CMP) a substrate having at least one surface comprising silicon dioxide using the chemical mechanical polishing (CMP) composition described above in Shallow Trench Isolation (STI) process. The polished oxide films can be CVD oxide, PECVD oxide, High density oxide, or Spin on oxide films.

The following non-limiting examples are presented to further illustrate the present invention.

### CMP Methodology

In the examples presented below, CMP experiments were run using the procedures and experimental conditions given below.

### GLOSSARY

### COMPONENTS

Ceria-coated Silica: used as abrasive having a particle size of approximately 100 nanometers (nm); such ceria-coated silica particles can have a particle size of ranged from approximately 20 nanometers (nm) to 500 nanometers (nm);
Ceria-coated Silica particles (with varied sizes) were supplied by JGC Inc. in Japan and were made by methods described in patent publications JP2013119131, JP2013133255, and WO 2016/159167; and patent applications JP2015-169967, and JP2015-183942.
Chemical additives, such as maltitol, D-Fructose, Dulcitol, D-sorbitol, gluconic acid, mucic acid, tartaric acid and other chemical raw materials were supplied by Sigma-Aldrich, St. Louis, MO
TEOS: tetraethyl orthosilicate
Polishing Pad: Polishing pad, IC1010 and other pads were used during CMP, supplied by DOW, Inc.

### PARAMETERS

### General

Å or A: angstrom(s) - a unit of length
BP: back pressure, in psi units
CMP: chemical mechanical planarization = chemical mechanical polishing
CS: carrier speed
DF: Down force: pressure applied during CMP, units psi
min: minute(s)
ml: milliliter(s)
mV: millivolt(s)
psi: pounds per square inch
PS: platen rotational speed of polishing tool, in rpm (revolution(s) per minute)
SF: composition flow, ml/min
Wt. %: weight percentage (of a listed component)
TEOS: SiN Selectivity: (removal rate of TEOS)/ (removal rate of SiN)
HDP: high density plasma deposited TEOS

TEOS or HDP Removal Rates: Measured TEOS or HDP removal rate at a given down pressure. The down pressure of the CMP tool was 2.0, 3.0 or 4.0 psi in the examples listed above.

SiN Removal Rates: Measured SiN removal rate at a given down pressure. The down pressure of the CMP tool was 3.0 psi in the examples listed.

### Metrology

Films were measured with a ResMap CDE, model 168, manufactured by Creative Design Engineering, Inc, 20565 Alves Dr., Cupertino, CA, 95014. The ResMap tool is a four-point probe sheet resistance tool. Forty-nine-point diameter scan at 5mm edge exclusion for film was taken.

### CMP Tool

The CMP tool that was used is a 200mm Mirra, or 300mm Reflexion manufactured by Applied Materials, 3050 Boweres Avenue, Santa Clara, California, 95054. An IC1000 pad supplied by DOW, Inc, 451 Bellevue Rd., Newark, DE 19713 was used on platen 1 for blanket and pattern wafer studies.

The IC1010 pad or other pad was broken in by conditioning the pad for 18 mins. At 7 lbs. down force on the conditioner. To qualify the tool settings and the pad break-in two tungsten monitors and two TEOS monitors were polished with Versum^{®} STI2305 composition, supplied by Versum Materials Inc. at baseline conditions.

### Wafers

Polishing experiments were conducted using PECVD or LECVD or HD TEOS wafers. These blanket wafers were purchased from Silicon Valley Microelectronics, 2985 Kifer Rd., Santa Clara, CA 95051.

### Polishing Experiments

In blanket wafer studies, oxide blanket wafers, and SiN blanket wafers were polished at baseline conditions. The tool baseline conditions were: table speed; 87 rpm, head speed: 93 rpm, membrane pressure; 2.0 psi, inter-tube pressure; 2.0 psi, retaining ring pressure; 2.9 psi, composition flow; 200 ml/min.

The composition was used in polishing experiments on patterned wafers (MIT860), supplied by SWK Associates, Inc. 2920 Scott Blvd. Santa Clara, CA 95054). These wafers were measured on the Veeco VX300 profiler/AFM instrument. The 3 different sized pitch structures were used for oxide dishing measurement. The wafer was measured at center, middle, and edge die positions.

TEOS: SiN Selectivity: (removal rate of TEOS)/ (removal rate of SiN) obtained from the STI CMP polishing compositions were tunable.

### Working Examples

In the following working examples, a STI polishing composition comprising 0.2 wt.% cerium-coated silica, a biocide ranging from 0.0001 wt.% to 0.05 wt.%, and deionized water was prepared as reference(ref.).

The working polishing compositions were prepared with the reference (0.2 wt.% cerium-coated silica, a biocide ranging from 0.0001 wt.% to 0.05 wt.%, and deionized water) and a disclosed chemical additive in the range of 0.0025 wt.% to 0.015% wt.%.

### Example 1

In Example 1, the polishing compositions used were shown in Table 1. The reference sample was made using 0.2 wt.% ceria-coated silica plus very low concentration of biocide. The chemical additive, gluconic acid was used at 0.01 wt.%. Both samples have same pH values at around 5.35.

The removal rates (RR at Å/min) for different films were tested. The effects of chemical additive gluconic acid on the film removal rates and selectivity were observed.

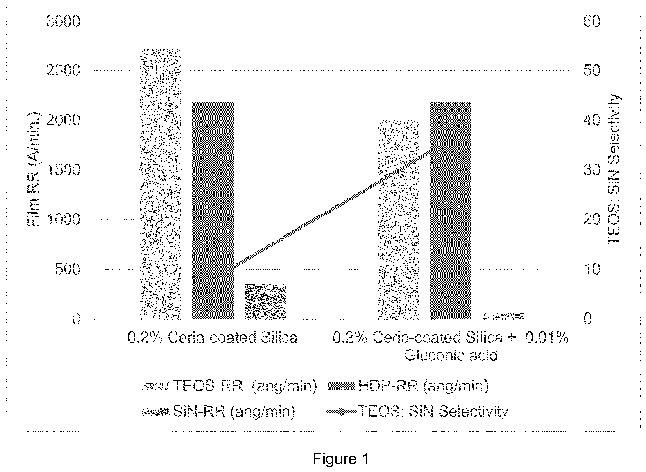

The test results were listed in Table 1 and shown in Figure 1 respectively.

**Table 1. Effects of Gluconic Acid on Film RR (Å /min.) & TEOS: SiN Selectivity**

| Compositions | TEOS-RR (ang/min) | HDP-RR (ang/min) | SiN-RR (ang/min) | TEOS: SiN Selectivity |
|---|---|---|---|---|
| 0.2% Ceria-coated Silica | 2718 | 2180 | 349 | 8:1 |
| 0.2% Ceria-coated Silica + 0.01% Gluconic acid | 2015 | 2183 | 56 | 36:1 |

As the results shown in Table 1 and Figure 1, the addition of gluconic acid in the polishing composition effectively suppressed SiN removal rates while still afforded high TEOS and HDP film removal rates, and thus provided much higher TEOS: SiN film selectivity than the reference sample without using chemical additive gluconic acid.

Thus, the polishing compositions provided the suppressed SiN film removal rates and high Oxide: SiN selectivity.

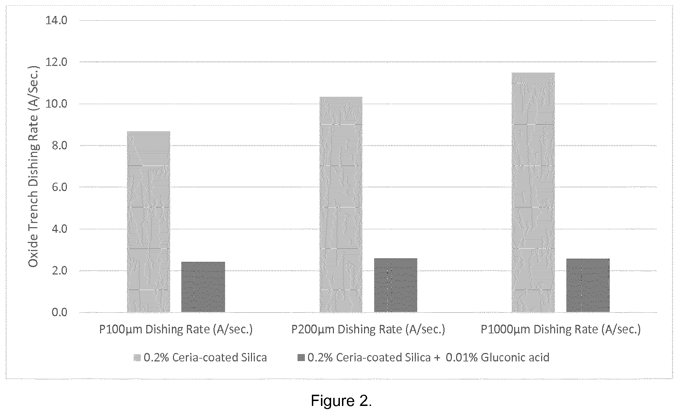

The effects of the chemical additive, gluconic acid, in the polishing composition on oxide trench dishing rates were tested. The results were listed in Table 2 and depicted in Figure 2.

**Table 2. Effects of Gluconic Acid on Oxide Trench Dishing Rate**

| Compositions | **P100µm Dishing Rate (A/sec.)** | **P200µm Dishing Rate (A/sec.)** | **P1000µm Dishing Rate (A/sec.)** |
|---|---|---|---|
| 0.2% Ceria-coated Silica | 8.7 | 10.3 | 11.5 |
| 0.2% Ceria-coated Silica + 0.01% Gluconic acid | 2.4 | 2.6 | 2.6 |

As the results shown in Table 2 and Figure 2, the addition of the chemical additive, gluconic acid, in the polishing composition effectively reduced oxide trench dishing rates at least by >72% across different sized oxide trench features comparing with the reference sample without using gluconic acid.

The effects of addition of the chemical additive, gluconic acid, in the polishing compositions were also observed on oxide trench loss rates (A/sec.) while comparing the polishing results from the reference sample without using gluconic acid as additive.

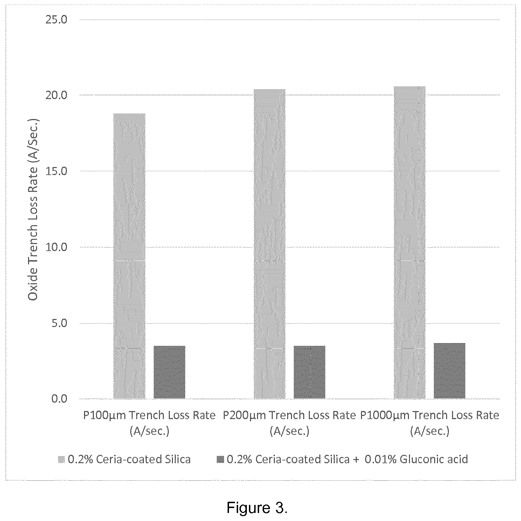

The test results were listed in Table 3 and depicted in Figure 3 respectively.

**Table 3. Effects of Gluconic Acid on Oxide Trench Loss Rates (A/Sec.)**

| Com position | P100µm Trench Loss Rate (A/sec.) | P200µm Trench Loss Rate (A/sec.) | P1000µm Trench Loss Rate (A/sec.) |
|---|---|---|---|
| 0.2% Ceria-coated Silica | 18.8 | 20.4 | 20.6 |
| 0.2% Ceria-coated Silica + 0.01% Gluconic acid | 3.5 | 3.5 | 3.7 |

As the results shown in Table 3 and Figure 3, the addition of the chemical additive, gluconic acid, in the polishing composition, very effectively reduced oxide trench loss rates at least by >81% across different sized oxide trench features than the reference sample without using the chemical additive, gluconic acid.

The effects of addition of the chemical additive, gluconic acid, in the polishing compositions were also observed on oxide trench dishing vs over polishing times while comparing the polishing results from the reference sample without using gluconic acid as additive.

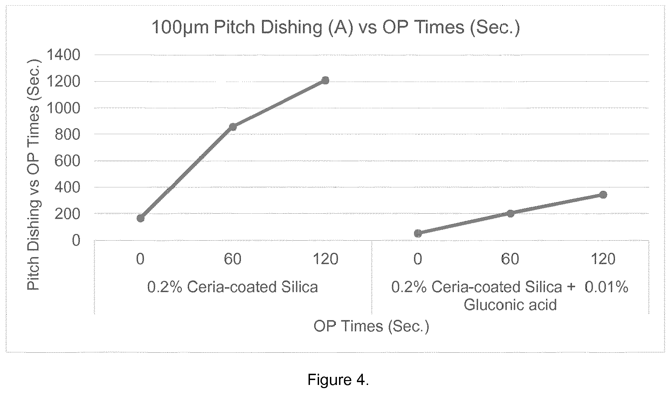

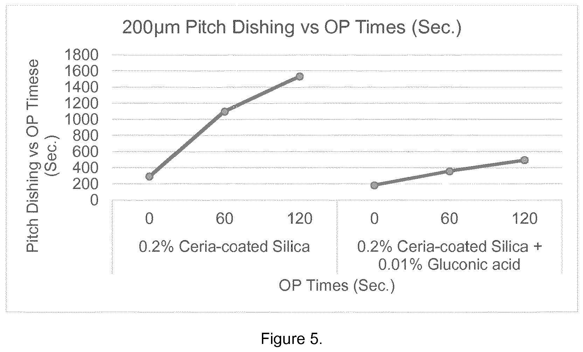

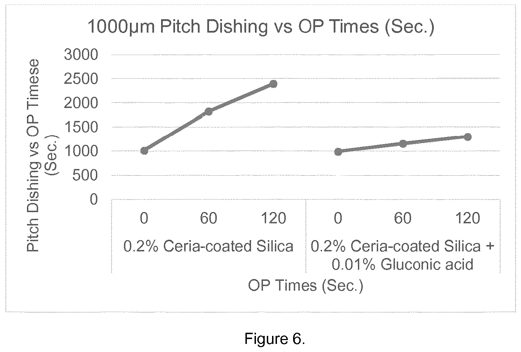

The test results on the effects of chemical additive gluconic acid in the polishing compositions on oxide trench dishing vs over polishing times were listed in Table 4, and depicted in Figure 4, Figure 5 and Figure 6 respectively.

**Table 4. Effects of Gluconic Acid on Oxide Trench Dishing vs OP Times (Sec.)**

| Compositions | Polish Time (Sec.) | 100µm Pitch Dishing | 200µm Pitch Dishing | 1000µm Pitch Dishing |
|---|---|---|---|---|
| 0.2% Ceria-coated Silica | 0 | 165 | 291 | 1013 |
| | 60 | 857 | 1096 | 1821 |
| | 120 | 1207 | 1531 | 2392 |
| 0.2% Ceria-coated Silica + 0.01% Gluconic acid | 0 | 52 | 182 | 992 |
| | 60 | 203 | 355 | 1158 |
| | 120 | 344 | 494 | 1301 |

As the results shown in Table 4, Figure 4, Figure 5, and Figure 6, the addition of the chemical additive, gluconic acid, in the polishing composition, very effectively reduced oxide trench dishing and improved over polishing stability window vs different over polishing times across different sized oxide trench features than the reference sample without using the chemical additive, gluconic acid.

Thus, the CMP composition comprised of the chemical additive suppressed SiN removal rates and increasing TEOS: SiN film selectivity, and very effectively reduced oxide trench dishing and provided improved topography on the polished patterned wafers while still afforded high TEOS and HDP film removal rates while comparing the polishing results from the reference sample without using gluconic acid as chemical additive.

### Example 2

In Example 2, the polishing composition were prepared as shown in Table 5. The chemical additive gluconic acid were used at different wt.%. pH for the compositions was all around 5.35.

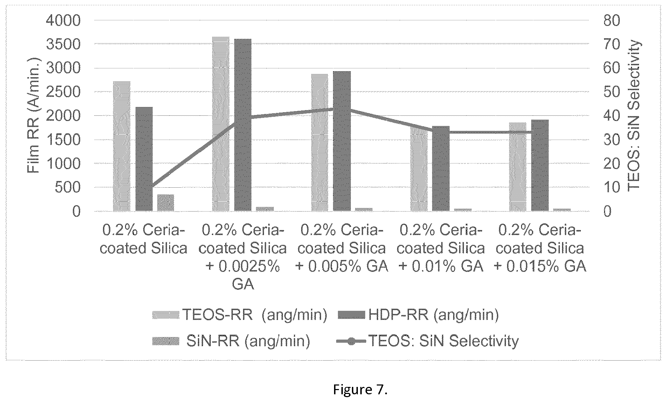

The various film polishing removal rates and TEOS: SiN selectivity results were listed in Table 5 and depicted in Figure 7.

**Table 5. Effects of Gluconic Acid (GA)% on Film RR (Å /min.) & TEOS: SiN Selectivity**

| Compositions | **TEOS-R (ang/min)** | **HDP-R (ang/min)** | **SiN-R (ang/min)** | **TEOS: SiN Selectivity** |
|---|---|---|---|---|
| 0.2% Ceria-coated Silica | 2718 | 2180 | 349 | 8:1 |
| 0.2% Ceria-coated Silica + 0.0025% GA | 3655 | 3609 | 93 | 39:1 |
| 0.2% Ceria-coated Silica + 0.005% GA | 2875 | 2932 | 67 | 43:1 |
| 0.2% Ceria-coated Silica +0.01% GA | 1754 | 1767 | 53 | 33:1 |
| 0.2% Ceria-coated Silica + 0.015% GA | 1854 | 1914 | 57 | 33:1 |
| 0.2% Ceria-coated Silica + 0.1% GA | 110 | 91 | 49 | 2:1 |

As the results shown in Table 5 and Figure 7, all compositions with different concentrations of gluconic acid provided a stable suppressed SiN removal rates. All compositions except the composition with 0.1 wt.% gluconic acid still afforded high TEOS and HDP film removal rates, and provided much higher TEOS: SiN film selectivity than the reference sample without using chemical additive gluconic acid. The composition with 0.1 wt.% gluconic acid suppressed the removal rates for all films tested and provided very low Oxide: SiN selectivity.

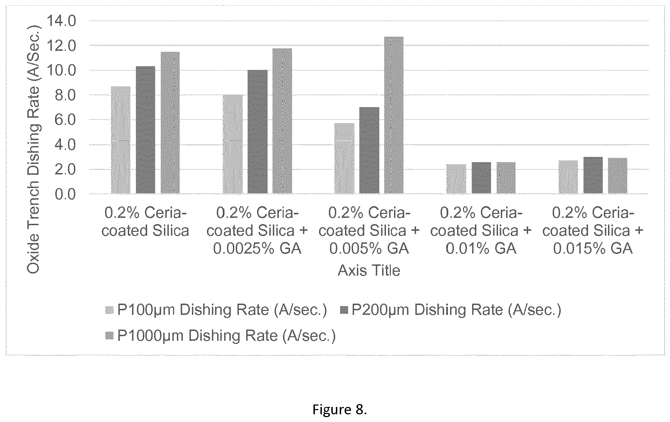

The Oxide Trench Dishing Rate using the compositions were also tested. The test results were listed in Table 6 and Figure 8.

**Table 6. Effects of Gluconic Acid% on Oxide Trench Dishing Rate**

| Compositions | **P100µm Dishing Rate (A/sec.)** | **P200µm Dishing Rate (A/sec.)** | **P1000µm Dishing Rate (A/sec.)** |
|---|---|---|---|
| 0.2% Ceria-coated Silica | 8.7 | 10.3 | 11.5 |
| 0.2% Ceria-coated Silica + 0.0025% GA | 8.0 | 10.0 | 11.8 |
| 0.2% Ceria-coated Silica + 0.005% GA | 5.7 | 7.0 | 12.7 |
| 0.2% Ceria-coated Silica + 0.01% GA | 2.4 | 2.6 | 2.6 |
| 0.2% Ceria-coated Silica + 0.015% GA | 2.7 | 3.0 | 2.9 |

As the results shown in Table 6 and Figure 8, the addition of 0.005 wt. % gluconic acid started to reduce oxide trench dishing rates by >32 % for 100µm and 200 µm. The addition of gluconic acid at 0.01 wt.% or > 0.01 wt.% concentrations very effectively reduced oxide trench dishing rates at least by >70% across different sized oxide trench features.

The effects of addition of the chemical additive, gluconic acid, used at different concentrations in the polishing compositions were also observed on oxide trench loss rates (A/sec.) while comparing the polishing results from the reference sample without using gluconic acid as additive.

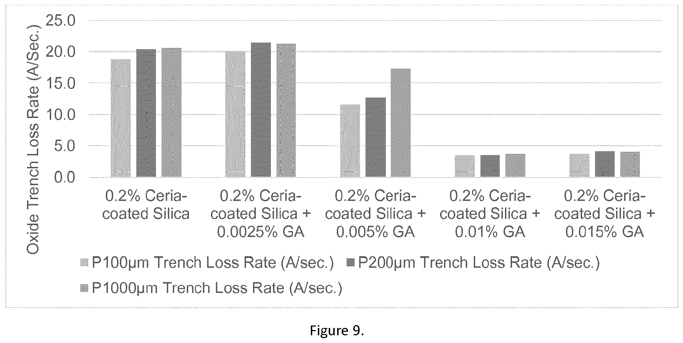

The test results were listed in Table 7 and shown in Figure 9 respectively.

**Table 7. Effects of Gluconic Acid% on Oxide Trench Loss Rates (A/Sec.)**

| Compositions | P100µm Trench Loss Rate (A/sec.) | P200µm Trench Loss Rate (A/sec.) | P1000µm Trench Loss Rate (A/sec.) |
|---|---|---|---|
| 0.2% Ceria-coated Silica | 18.8 | 20.4 | 20.6 |
| 0.2% Ceria-coated Silica + 0.0025% GA | 20.0 | 21.4 | 21.3 |
| 0.2% Ceria-coated Silica + 0.005% GA | 11.6 | 12.7 | 17.3 |
| 0.2% Ceria-coated Silica + 0.01% GA | 3.5 | 3.5 | 3.7 |
| 0.2% Ceria-coated Silica + 0.015% GA | 3.7 | 4.1 | 4.1 |

As the results shown in Table 7 and Figure 9, the addition of 0.005 wt. % gluconic acid started to reduced oxide trench loss rates at least by >16 % for 1000µm and by 38 % for 100µm and 200 µm. The addition of gluconic acid at 0.01 wt.% or > 0.01 wt.% concentrations very effectively reduced oxide trench loss rates at least by >81% across different sized oxide trench features.

The effects of addition of the chemical additive, gluconic acid, used at different concentrations in the polishing compositions were also observed on oxide trench dishing vs over polishing times while comparing the polishing results from the reference sample without using gluconic acid as additive.

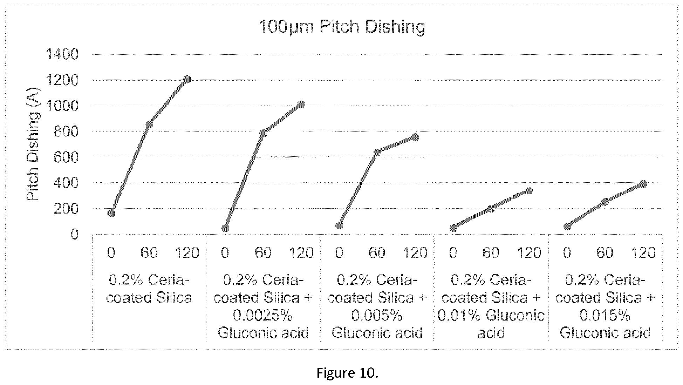

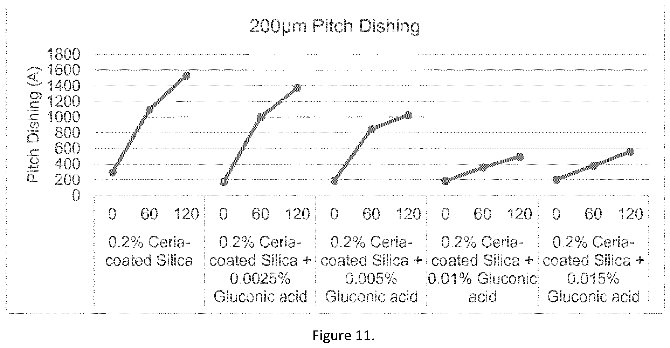

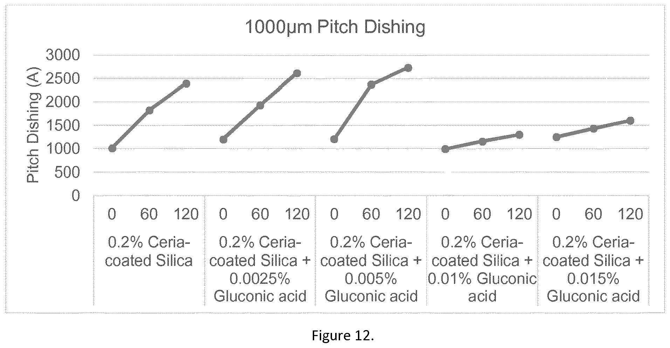

The test results were listed in Table 8 and shown in Figure 10, Figure 11 and Figure 12 respectively.

**Table 8. Effects of Gluconic Acid% on Oxide Trench Dishing vs OP Times (Sec.)**

| Compositions | Over Polish Time (Sec.) | 100um pitch dishing | 200um pitch dishing | 1000um pitch dishing |
|---|---|---|---|---|
| 0.2% Ceria-coated Silica | 0 | 165 | 291 | 1013 |
| | 60 | 857 | 1096 | 1821 |
| | 120 | 1207 | 1531 | 2392 |
| 0.2% Ceria-coated Silica + 0.0025% Gluconic Acid | 0 | 51 | 167 | 1201 |
| | 60 | 786 | 1002 | 1932 |
| | 120 | 1012 | 1370 | 2616 |
| 0.2% 0.2% Ceria-coated Silica + 0.005% Gluconic Acid | 0 | 72 | 186 | 1205 |
| | 60 | 641 | 845 | 2371 |
| | 120 | 757 | 1026 | 2732 |
| 0.2% Ceria-coated Silica + 0.01% Gluconic Acid | 0 | 52 | 182 | 992 |
| | 60 | 203 | 355 | 1158 |
| | 120 | 344 | 494 | 1301 |
| 0.2% Ceria-coated Silica + 0.015% Gluconic Acid | 0 | 65 | 200 | 1251 |
| | 60 | 253 | 380 | 1433 |
| | 120 | 393 | 559 | 1601 |

As the results shown in Table 8, Figure 10, Figure 11, and Figure 12, even with the addition of 0.0025 wt. % gluconic acid, the composition started to reduced oxide trench dishing and improved over polishing stability window. As the concentration of gluconic acid increased within the tested concentrations, the effect was more pronounced.

Again, the CMP composition comprised of the chemical additive having different testing concentrations suppressed SiN removal rates and increasing TEOS: SiN film selectivity, and very effectively reduced oxide trench dishing and provided improved topography on the polished patterned wafers while still afforded high TEOS and HDP film removal rates while comparing the polishing results from the reference sample without using gluconic acid as chemical additive.

### Example 3

In Example 3, different pH conditions were tested with gluconic acid used as chemical additive at 0.01 wt.% concentration. The tested compositions and pH conditions were listed used as in Table 9.

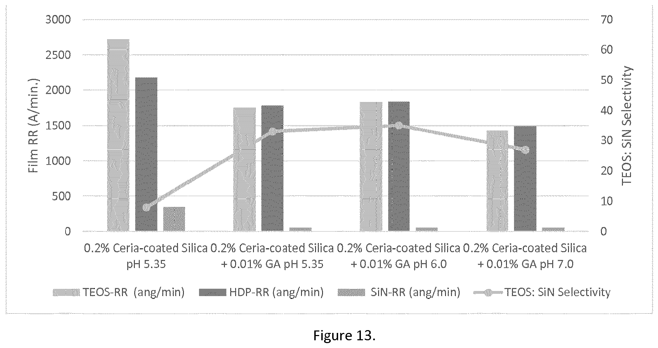

The film removal rates and TEOS: SiN selectivity were listed in Table 9 and depicted in Figure 13.

**Table 9. Effects of pH and 0.01 wt.% Gluconic Acid on Film RR (Å /min.) & TEOS: SiN Selectivity**

| Compositions | TEOS-RR (ang/min) | HDP-RR (ang/min) | SiN-RR (ang/min) | TEOS: SiN Selectivity |
|---|---|---|---|---|
| 0.2% Ceria-coated Silica pH 5.35 | 2718 | 2180 | 349 | 8:1 |
| 0.2% Ceria-coated Silica + 0.01% GA pH 5.35 | 1754 | 1787 | 53 | 33:1 |
| 0.2% Ceria-coated Silica + 0.01% GA pH 6.0 | 1836 | 1839 | 52 | 35:1 |
| 0.2% Ceria-coated Silica + 0.01% GA pH 7.0 | 1429 | 1488 | 52 | 27:1 |

As the results shown in Table 9 and Figure 13, the SiN film removal rates were significantly reduced by at least >82%, and TEOS: SiN selectivity were increased by at least >300% at all testing pH conditions while comparing the polishing composition without using gluconic acid as chemical additive.

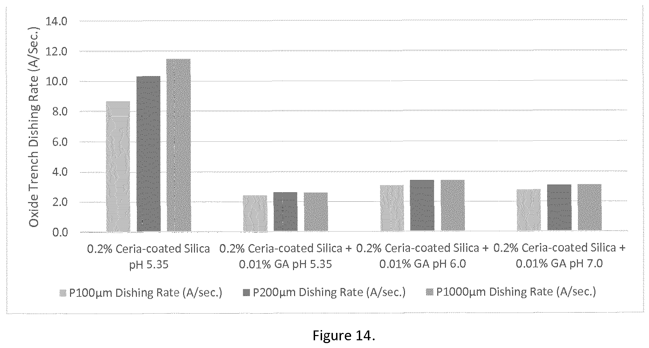

The effects of pH conditions on the composition using 0.01 wt.% gluconic acid as chemical additive on the various sized oxide trench feature dishing rates were observed and the results were listed in Table 10 and depicted in Figure 14.

**Table 10. Effects of pH with 0.01% Gluconic Acid on Oxide Trench Dishing Rate**

| Compositions | P100µm Dishing Rate (A/sec.) | P200µm Dishing Rate (A/sec.) | P1000µm Dishing Rate (A/sec.) |
|---|---|---|---|
| 0.2% Ceria-coated Silica pH 5.35 | 8.7 | 10.3 | 11.5 |
| 0.2% Ceria-coated Silica + 0.01% GA pH 5.35 | 2.4 | 2.6 | 2.6 |
| 0.2% Ceria-coated Silica + 0.01% GA pH 6.0 | 3.1 | 3.4 | 3.4 |
| 0.2% Ceria-coated Silica + 0.01% GA pH 7.0 | 2.8 | 3.1 | 3.1 |

As the results shown in Table 10 and Figure 14, in general, using 0.01 wt.% gluconic acid as chemical additive in the invented polishing composition significantly reduced oxide trench dishing rates at all testing pH conditions while comparing the polishing composition without using gluconic acid as chemical additive.

The invented STI CMP polishing compositions herein can be used at the wide pH range which include acidic, neutral or alkaline.

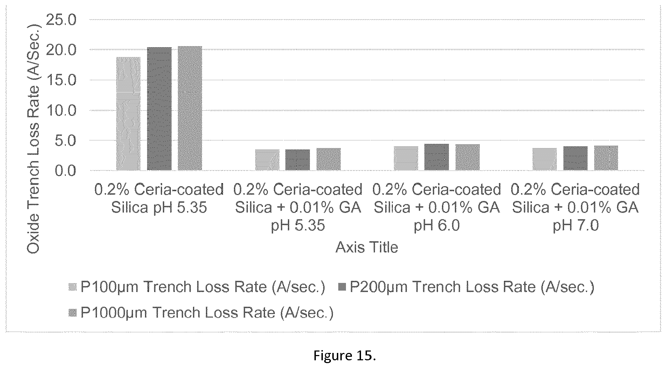

The effects of pH conditions on the composition using 0.01 wt.% gluconic acid as chemical additive on the various sized oxide trench loss rates were observed and the results were listed in Table 11 and depicted in Figure 15.

**Table 11. Effects of pH with 0.01% Gluconic Acid on Oxide Trench Loss Rate**

| Compositions | P100µm Trench Loss Rate (A/sec.) | P200µm Trench Loss Rate (A/sec.) | P1000µm Trench Loss Rate (A/sec.) |
|---|---|---|---|
| 0.2% Ceria-coated Silica pH 5.35 | 18.8 | 20.4 | 20.6 |
| 0.2% Ceria-coated Silica + 0.01% GA pH 5.35 | 3.5 | 3.5 | 3.7 |
| 0.2% Ceria-coated Silica + 0.01% GA pH 6.0 | 4.0 | 4.4 | 4.4 |
| 0.2% Ceria-coated Silica + 0.01% GA pH 7.0 | 3.7 | 4.0 | 4.1 |

As the results shown in Table 11 and Figure 15, in general, using 0.01 wt.% gluconic acid as chemical additive in the invented polishing composition significantly reduced oxide trench loss rates at all testing pH conditions while comparing the polishing composition without using gluconic acid as chemical additive.

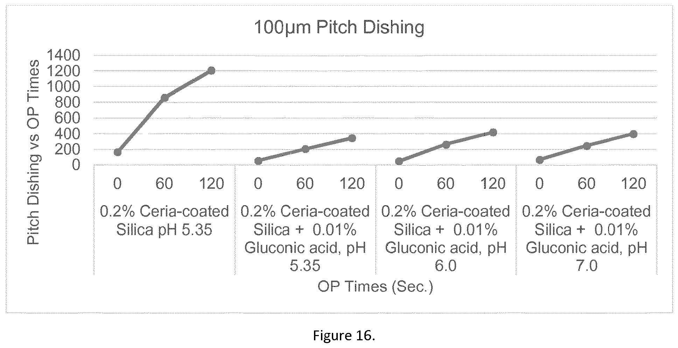

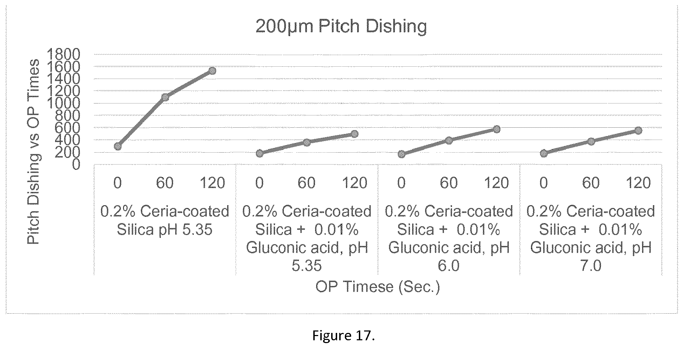

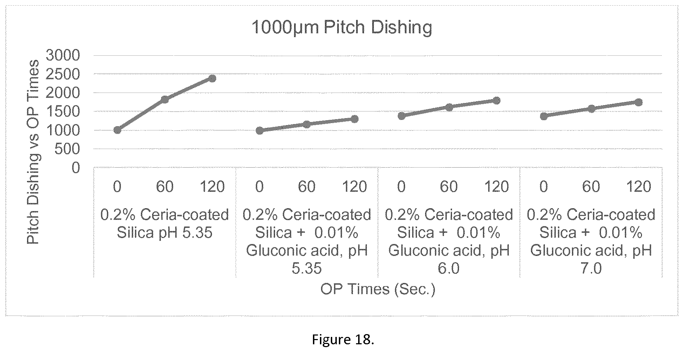

The effects of chemical additive, gluconic acid, used at 0.01 wt.% at different pH conditions in the polishing compositions were also observed on oxide trench dishing vs over polishing times while comparing the polishing results from the reference sample without using gluconic acid as additive. The test results were listed in Table 12, Figure 16, Figure 17 and Figure 18 respectively.

**Table 12. Effects of pH with 0.01% Gluconic Acid% on Oxide Trench Dishing vs OP Times (Sec.)**

| Compositions | Over Polishing Times (Sec.) | 100µm Pitch Dishing | 200µm Pitch Dishing | 1000µm Pitch Dishing |
|---|---|---|---|---|
| 0.2% Ceria-coated Silica pH 5.35 | 0 | 165 | 291 | 1013 |
| | 60 | 857 | 1096 | 1821 |
| | 120 | 1207 | 1531 | 2392 |
| 0.2% Ceria-coated Silica + 0.01% Gluconic acid, pH 5.35 | 0 | 52 | 182 | 992 |
| | 60 | 203 | 355 | 1158 |
| | 120 | 344 | 494 | 1301 |
| 0.2% Ceria-coated Silica + 0.01% Gluconic acid, pH 6.0 | 0 | 47 | 168 | 1386 |
| | 60 | 262 | 389 | 1618 |
| | 120 | 418 | 577 | 1794 |
| 0.2% Ceria-coated Silica + 0.01% Gluconic acid, pH 7.0 | 0 | 65 | 182 | 1380 |
| | 60 | 245 | 372 | 1575 |
| | 120 | 399 | 552 | 1753 |

As the results shown in Table 12, Figure 16, Figure 17, and Figure 18, when gluconic acid is used as chemical additive at 0.01 wt.% at all testing pH conditions, the oxide trench dishing was significantly reduced, and over polishing stability window were significantly improved across different sized oxide trench features than the reference sample without using the chemical additive, gluconic acid.

### Example 4

In Example 4, gluconic acid, mucic acid or tartaric acid; ceria-coated silica composite particles were used in different compositions. A reference polishing composition without using any chemical additives was also listed. A biocide ranging from 0.0001 wt.% to 0.05 wt.%, and deionized water were also used in al compositions. The tested compositions had same pH of 5.3.

Removal rates for various film were listed in Table 13.

**Table 13. Effects of Ceria-coated Silica Abrasives on Film RR (Å/min.)**

| Compositions | **TEOS-R (ang/min)** | **HDP-R (ang/min)** | **PECVD SiN-R (ang/min)** | **LPCVD SiN-R (ang/min)** |
|---|---|---|---|---|
| 0.2% Ceria-coated Silica | 2718 | 2180 | 349 | NA |
| 0.2% Ceria-coated Silica + 0.01% Gluconic Acid | 2375 | 1975 | 45 | 39 |
| 0.2% Ceria-coated Silica + 0.01% Mucic Acid | 2222 | 2216 | 46 | 33 |
| 0.2% Ceria-coated Silica + 0.01% Tartaric Acid | 2251 | 2368 | 69 | 35 |

When gluconic acid, mucic acid or tartaric acid was used at 0.01 wt.% with ceria-coated silica as abrasives, PECVD SiN film removal rates were significantly suppressed while comparing to the PECVD SiN film removal rate obtained from the reference polishing composition not using any additive.

Such results demonstrated that these organic acids with one or two carboxyl group(s) and two or more hydroxyl groups are very effective SiN removal rate suppressing agents.

Total defect count reduction on polished TEOS and SiN wafers were tested with STI oxide polishing compositions using ceria-coated silica composite particles as abrasives.

The total defect count comparison results were listed in Table 14.

**Table 14. Total Defect Count Comparison of Ceria-Coated Silica Based STI Oxide Polishing Compositions**

| Compositions | TEOS 0.07um LPD | TEOS 0.13um LPD | LPCVD SiN 0.1um LPD | LPCVD SiN 0.13um LPD |
|---|---|---|---|---|
| 0.2% Ceria-coated Silica + 0.01% Gluconic Acid | 3042 | 915 | 3426 | 2666 |
| 0.2% Ceria-coated Silica + 0.01% Mucic Acid | 2244 | 165 | 2738 | 2104 |
| 0.2% Ceria-coated Silica + 0.01% Tartaric Acid | 1100 | 106 | 2890 | 1855 |

As the results shown in Table 14, at the same pH conditions and with same chemical additive of gluconic acid at 0.01 wt.%, the polishing composition of using ceria-coated silica composite particles as abrasives afforded significantly lower total defect counts on both polished TEOS and SiN films.

The results shown in Table 14 also demonstrated that the polishing compositions using mucic acid or tartaric acid reduced more total defect counts than the polishing composition using gluconic acid on all test wafers.

### Example 5

In Example 5, under same pH conditions, the polishing compositions using gluconic acid, mucic acid or tartaric acid as chemical additive, were tested vs the reference polishing composition without using any chemical additives.

The tested compositions, pH conditions, HPD film removal rates, P200 trench loss rates and P200 Trench/Blanket Ratios were listed in Table 15.

**Table 15. Effects of Chemical Additives on HDP RR, Trench Loss RR & Trench Loss/Blanket Loss Ratio**

| Compositions | P200 Trench Rate (A/sec.) | P200 Trench Rate (Å/min.) | P200 Trench/ Blanket Ratio | HDP RR(Å /min) |
|---|---|---|---|---|
| 0.2% Ceria-coated Silica | 20.4 | 1224 | 0.42 | 2180 |
| 0.2% Ceria-coated Silica + 0.01% Gluconic Acid | 4.7 | 283 | 0.12 | 2375 |
| 0.2% Ceria-coated Silica + 0.01% Mucic Acid | 4.0 | 240 | 0.11 | 2222 |
| 0.2% Ceria-coated Silica + 0.01% Tartaric Acid | 8.5 | 512 | 0.23 | 2251 |

As the results shown in Table 15, under the same pH conditions, the compositions using a chemical additive at same concentrations at 0.01 wt.% offered the similar HDP film removal rates, but significantly reduced trench loss rate and trench loss rate/blanket loss rate ratios comparing with the reference composition without the use of any chemical additive.

The over polishing times vs the trench dishing were tested. The results were listed in Table 16.

**Table 16. Effects of Chemical Additives on OP Times(Sec.) vs Trench Dishing (Å)**

| Compositions | Polish Time (Sec.) | 100um pitch dishing | 200um pitch dishing | Blanket HDP RR (Å /min) |
|---|---|---|---|---|
| 0.2% Ceria-coated Silica | 0 | 165 | 291 | 2180 |
| | 60 | 857 | 1096 | |
| | 120 | 1207 | 1531 | |
| 0.2% CPOP + 0.01% Gluconic Acid | 0 | 160 | 336 | 2375 |
| | 60 | 602 | 552 | |
| | 120 | 874 | 741 | |
| 0.2% CPOP + 0.01% Mucic Acid | 0 | 247 | 402 | 2222 |
| | 60 | 384 | 590 | |
| | 120 | 530 | 769 | |
| 0.2% CPOP + 0.01% Tartaric Acid | 0 | 196 | 350 | 2251 |
| | 60 | 498 | 775 | |
| | 120 | 757 | 1132 | |

As the results shown in Table 16, under the same pH conditions, the compositions using a chemical additive at same concentrations at 0.01 wt.% offered significantly lower trench dishing when 60 seconds or 120 second over polishing times were applied.

The results shown in Table 16 also demonstrated that mucic acid or gluconic acid appear to be more effective chemical additives in reducing trench dishing under different over polishing time conditions than tartaric acid as chemical additive in the polishing composition.

The embodiments of this invention listed above, including the working example, are exemplary of numerous embodiments that may be made of this invention. It is contemplated that numerous other configurations of the process may be used, and the materials used in the process may be elected from numerous materials other than those specifically disclosed.

## Claims

1. A chemical mechanical polishing composition comprising:
ceria-coated inorganic oxide particles;
0.0006 wt.% to 0.25 wt. % of a chemical additive comprising at least one organic carboxylic acid group(s), at least one carboxylate salt group, or at least one carboxylic ester group; and at least two hydroxyl functional groups in the same molecule;
water soluble solvent; and
optionally biocide and/or pH adjuster;
wherein the composition has a pH of 4 to 9.

2. The chemical mechanical polishing composition of Claim 1, wherein the chemical additive has a general molecular structure of: 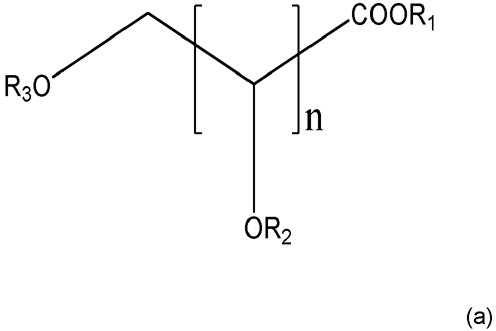 or 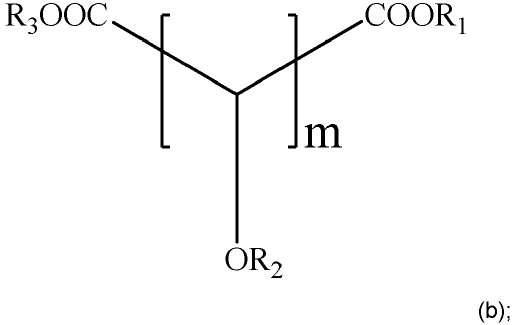 wherein n is selected from 1 to 12, m is selected from 2 to 12, and R1, R2, and R3 can be the same or different atoms or functional groups and are independently selected from the group consisting of hydrogen; alkyl; alkoxy; organic group with at least one hydroxyl groups; substituted organic sulfonic acid; substituted organic sulfonic acid salt; substituted organic carboxylic acid; substituted organic carboxylic acid salt; organic carboxylic ester; organic amine group; metal ion selected from the group comprising sodium ion, potassium ion, and ammonium ion; and combinations thereof; wherein at least two of R1, R2, and R3 are hydrogen atoms.

3. The chemical mechanical polishing composition of Claim 1 or 2, wherein the ceria-coated inorganic oxide particles range from 0.1 wt.% to 5 wt.% and are selected from the group consisting of ceria-coated colloidal silica, ceria-coated high purity colloidal silica, ceria-coated alumina, ceria-coated titania, ceria-coated zirconia particles and combinations thereof.

4. The chemical mechanical polishing composition of any preceding claim, wherein the water-soluble solvent is selected from the group consisting of deionized (DI) water, distilled water, and alcoholic organic solvents.

5. The chemical mechanical polishing composition of any preceding claim, wherein the chemical additive ranges from 0.0007 wt.% to 0.1 wt. %.

6. The chemical mechanical polishing composition of any preceding claim, wherein the composition has a pH of 4.5 to 7.5

7. The chemical mechanical polishing composition of any preceding claim, wherein the chemical additive is selected from the group consisting of tartaric acid, cholic acid, shikimic acid, mucic acid with two acid groups, asiatic acid, 2,2-Bis(hydroxymethyl)propionic acid, gluconic acid, sodium gluconate salt, potassium gluconate salt, gluconate ammonium salt, gluconic acid methyl ester, and combinations thereof.

8. The chemical mechanical polishing composition of any preceding claim, wherein the chemical additive is selected from the group consisting of gluconic acid, gluconic acid methyl ester, gluconic acid ethyl ester, and combinations thereof.

9. The chemical mechanical polishing composition of any preceding claim, wherein the composition comprises ceria-coated colloidal silica particles; the chemical additive selected from the group consisting of gluconic acid, gluconate salts, gluconic acid alkyl esters and combinations thereof; and water.

10. The chemical mechanical polishing composition of any preceding claim, wherein the composition further comprises at least one of
from 0.0005 wt.% to 0.025 wt.% of the biocide having active ingredients of 5-chloro-2-methyl-4-isothiazolin-3-one and 2-methyl- -isothiazolin-3-one;
from 0.01 wt.% to 0.5 wt.% of the pH adjusting agent selected from the group consisting of nitric acid, hydrochloric acid, sulfuric acid, phosphoric acid, other inorganic or organic acids, and mixtures thereof for acidic pH conditions; or selected from the group consisting of sodium hydride, potassium hydroxide, ammonium hydroxide, tetraalkyl ammonium hydroxide, organic quaternary ammonium hydroxide compounds, organic amines, and combinations thereof for alkaline pH conditions.

11. A method of chemical mechanical polishing (CMP) a semiconductor substrate having at least one surface comprising silicon oxide film, comprising
providing the semiconductor substrate;
providing a polishing pad;
providing chemical mechanical polishing (CMP) composition according to any one of Claims 1 to 10;
contacting the surface of the semiconductor substrate with the polishing pad and the chemical mechanical polishing composition; and
polishing the least one surface comprising silicon dioxide.

12. A system of chemical mechanical polishing (CMP) a semiconductor substrate having at least one surface comprising silicon oxide film, comprising
a. the semiconductor substrate;
b. a chemical mechanical polishing (CMP) composition according to any one of Claims 1 to 10;
c. a polishing pad;
wherein in use of the system the at least one surface comprising silicon oxide film is in contact with the polishing pad and the chemical mechanical polishing composition.

13. The method Claim 11; wherein
the silicon oxide film is selected from the group consisting of Chemical vapor deposition (CVD), Plasma Enhanced CVD (PECVD), High Density Deposition CVD(HDP), or spin on silicon oxide film.

14. The method of Claim 11, or 13, wherein the semiconductor substrate further comprises a silicon nitride surface.

15. The method of Claim 14, wherein the removal selectivity of silicon oxide: silicon nitride is greater than 25.

## Patentansprüche

1. Chemisch-mechanische Polierzusammensetzung, die Folgendes umfasst:
mit Cerdioxid beschichtete anorganische Oxidpartikel;
0,0006 Gew.-% bis 0,25 Gew.-% eines chemischen Additivs, das wenigstens eine organische Carbonsäuregruppe(n), wenigstens eine Carboxylatsalzgruppe oder wenigstens eine Carbonsäureestergruppe; und wenigstens zwei funktionelle Hydroxylgruppen in demselben Molekül umfasst;
ein wasserlösliches Lösungsmittel; und
optional ein Biozid und/oder einen pH-Wert-Einsteller;
wobei die Zusammensetzung einen pH-Wert von 4 bis 9 aufweist.

2. Chemisch-mechanische Polierzusammensetzung nach Anspruch 1, wobei das chemische Additiv eine allgemeine Molekularstruktur von Folgendem aufweist: 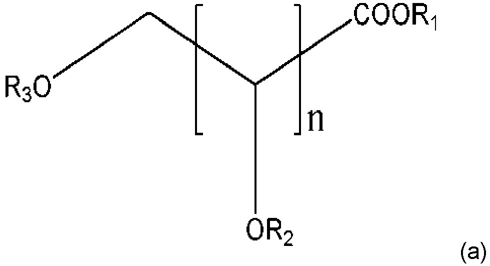 oder 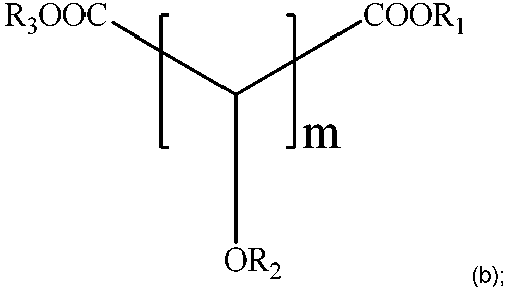 wobei n aus 1 bis 12 ausgewählt ist, m aus 2 bis 12 ausgewählt ist und R1, R2 und R3 dieselben oder unterschiedliche Atome oder funktionelle Gruppen sein können und unabhängig aus der Gruppe ausgewählt sind, die aus Wasserstoff; Alkyl; Alkoxy; einer organischen Gruppe mit wenigstens einer Hydroxylgruppe; einer substituierten organischen Sulfonsäure; einem substituierten organischen Sulfonsäuresalz; einer substituierten organischen Carbonsäure; einem substituierten organischen Carbonsäuresalz; einem organischen Carbonsäureester; einer organischen Amingruppe; einem Metallion, das aus der Gruppe ausgewählt ist, die ein Natriumion, ein Kaliumion und ein Ammoniumion umfasst; und Kombinationen davon besteht; wobei wenigstens zwei von R1, R2 und R3 Wasserstoffatome sind.

3. Chemisch-mechanische Polierzusammensetzung nach Anspruch 1 oder 2, wobei die mit Cerdioxid beschichteten anorganischen Oxidpartikel in einem Bereich von 0.1 Gew.-% bis 5 Gew.-% liegen und aus der Gruppe ausgewählt sind, die aus mit Cerdioxid beschichtetem kolloidalem Siliciumdioxid, mit Cerdioxid beschichtetem hochreinem kolloidalem Siliciumdioxid, mit Cerdioxid beschichtetem Aluminiumoxid, mit Cerdioxid beschichtetem Titandioxid, mit Cerdioxid beschichteten Zirconiumdioxidpartikeln und Kombinationen davon besteht.

4. Chemisch-mechanische Polierzusammensetzung nach einem der vorhergehenden Ansprüche, wobei das wasserlösliche Lösungsmittel aus der Gruppe ausgewählt ist, die aus deionisiertem (DI) Wasser, destilliertem Wasser und alkoholischen organischen Lösungsmitteln besteht.

5. Chemisch-mechanische Polierzusammensetzung nach einem der vorhergehenden Ansprüche, wobei das chemische Additiv in einem Bereich von 0,0007 Gew.-% bis 0,1 Gew.-% liegt.

6. Chemisch-mechanische Polierzusammensetzung nach einem der vorhergehenden Ansprüche, wobei die Zusammensetzung einen pH-Wert von 4,5 bis 7,5 aufweist.

7. Chemisch-mechanische Polierzusammensetzung nach einem der vorhergehenden Ansprüche, wobei das chemische Additiv aus der Gruppe ausgewählt ist, die aus Weinsäure, Cholsäure, Shikimisäure, Schleimsäure mit zwei Säuregruppen, Asiatsäure, 2,2-Bis(hydroxymethyl)propionsäure, Gluconsäure, Natriumgluconatsalz, Kaliumgluconatsalz, Gluconatammoniumsalz, Gluconsäuremethylester und Kombinationen davon besteht.

8. Chemisch-mechanische Polierzusammensetzung nach einem der vorhergehenden Ansprüche, wobei das chemische Additiv aus der Gruppe ausgewählt ist, die aus Gluconsäure, Gluconsäuremethylester, Gluconsäureethylester und Kombinationen davon besteht.

9. Chemisch-mechanische Polierzusammensetzung nach einem der vorhergehenden Ansprüche, wobei die Zusammensetzung mit Cerdioxid beschichtete kolloidale Siliciumdioxidpartikel; das chemische Additiv, das aus der Gruppe ausgewählt ist, die aus Gluconsäure, Gluconatsalzen, Gluconsäurealkylestern und Kombinationen davon besteht; und Wasser umfasst.

10. Chemisch-mechanische Polierzusammensetzung nach einem der vorhergehenden Ansprüche, wobei die Zusammensetzung ferner Folgendes umfasst:
0,0005 Gew.-% bis 0,025 Gew.-% des Biozids, das Wirkstoffe von 5-Chlor-2-methyl-4-isothiazolin-3-on und 2-Methyl-isothiazolin-3-on aufweist;
von 0,01 Gew-% bis 0,5 Gew.-% des pH-Wert-Einstellmittels, das aus der Gruppe ausgewählt ist, die aus Salpetersäure, Salzsäure, Schwefelsäure, Phosphorsäure, anderen anorganischen oder organischen Säuren und Mischungen davon für saure pH-Wert-Bedingungen besteht; oder aus der Gruppe ausgewählt ist, die aus Natriumhydrid, Kaliumhydroxid, Ammoniumhydroxid, Tetraalkylammoniumhydroxid, organischen quaternären Ammoniumhydroxidverbindungen, organischen Aminen und Kombinationen davon für alkalische pH-Wert-Bedingungen besteht.

11. Verfahren zum chemisch-mechanischen Polieren (CMP) eines Halbleitersubstrats, das wenigstens eine Oberfläche aufweist, die einen Siliciumoxidfilm umfasst, das Folgendes umfasst:
Bereitstellen des Halbleitersubstrats;
Bereitstellen eines Polierkissens;
die chemisch-mechanische Polier(CMP)-Zusammensetzung nach einem der Ansprüche 1 bis 10;
Inberührungbringen der Oberfläche des Halbleitersubstrats mit dem Polierkissen und der chemisch-mechanischen Polierzusammensetzung; und
Polieren der wenigstens einen Oberfläche, die Siliciumdioxid umfasst.

12. System zum chemisch-mechanischen Polieren (CMP) eines Halbleitersubstrats, das wenigstens eine Oberfläche aufweist, die einen Siliciumoxidfilm umfasst, das Folgendes umfasst:
a. das Halbleitersubstrat;
b. eine chemisch-mechanische Polier(CMP)-Zusammensetzung nach einem der Ansprüche 1 bis 10;
c. ein Polierkissen;
wobei in Verwendung des Systems die wenigstens eine Oberfläche, die dem Siliciumoxidfilm umfasst, mit dem Polierkissen und der chemisch-mechanischen Polierzusammensetzung in Berührung steht.

13. Verfahren nach Anspruch 11, wobei
der Siliciumoxidfilm aus der Gruppe ausgewählt ist, die aus chemischem Dampfniederschlag (Chemical vapor deposition - CVD), plasmaunterstütztem CVD (Plasma Enhanced CVD - PECVD), CVD eines Niederschlags hoher Dichte (High Density Deposition - HDP) oder einem aufgeschleudertem Siliciumoxidfilm besteht.

14. Verfahren nach Anspruch 11 oder 13, wobei das Halbleitersubstrat ferner eine Siliciumnitridoberfläche umfasst.

15. Verfahren nach Anspruch 14, wobei die Entfernungsselektivität von Siliciumoxid : Siliciumnitrid über 25 liegt.

## Revendications

1. Composition de polissage mécanique et chimique comprenant :
des particules d'oxyde inorganique revêtues d'oxyde de cérium ;
0,0006 % en poids à 0,25 % en poids d'un additif chimique comprenant au moins un groupe acide carboxylique organique, au moins un groupe sel carboxylate, ou au moins un groupe ester carboxylique ; et au moins deux groupes fonctionnels hydroxyles dans la même molécule ;
un solvant hydrosoluble ; et
éventuellement un biocide et/ou un ajusteur de pH ;
dans laquelle la composition a un pH de 4 à 9.

2. Composition de polissage mécanique et chimique selon la revendication 1, dans laquelle l'additif chimique a une structure moléculaire générale de : 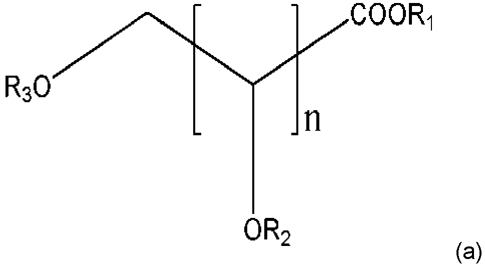 ou 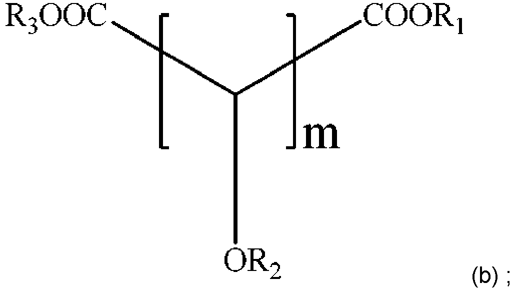 où n est choisi de 1 à 12, m est choisi de 2 à 12, et R1, R2 et R3 peuvent être des atomes ou des groupes fonctionnels identiques ou différents et sont indépendamment choisis dans le groupe constitué d'hydrogène ; alkyle ; alcoxy ; groupe organique avec au moins un groupe hydroxyle ; acide sulfonique organique substitué ; sel d'acide sulfonique organique substitué ; acide carboxylique organique substitué ; sel d'acide carboxylique organique substitué ; ester carboxylique organique ; groupe amine organique ; ion métallique choisi dans le groupe comprenant l'ion sodium, l'ion potassium et l'ion ammonium ; et leurs combinaisons ; au moins deux parmi R1, R2 et R3 étant des atomes d'hydrogène.

3. Composition de polissage mécanique et chimique selon la revendication 1 ou 2, dans laquelle les particules d'oxyde inorganique revêtues d'oxyde de cérium se situent dans la plage allant de 0,1 % en poids à 5 % en poids et sont choisies dans le groupe constitué de silice colloïdale revêtue d'oxyde de cérium, silice colloïdale revêtue d'oxyde de cérium de première qualité, alumine revêtue d'oxyde de cérium, oxyde de titane revêtu d'oxyde de cérium, particules de zircone revêtues d'oxyde de cérium et leurs combinaisons.

4. Composition de polissage mécanique et chimique selon l'une quelconque des revendications précédentes, dans laquelle le solvant hydrosoluble est choisi dans le groupe constitué d'eau déionisée (DI), d'eau distillée et de solvants organiques alcooliques.

5. Composition de polissage mécanique et chimique selon l'une quelconque des revendications précédentes, dans laquelle l'additif chimique se situe dans la plage allant de 0,0007 % en poids à 0,1 % en poids.

6. Composition de polissage mécanique et chimique selon l'une quelconque des revendications précédentes, dans laquelle la composition a un pH de 4,5 à 7,5.

7. Composition de polissage mécanique et chimique selon l'une quelconque des revendications précédentes, dans laquelle l'additif chimique est choisi dans le groupe constitué par l'acide tartrique, l'acide cholalique, l'acide shikimique, l'acide mucique avec deux groupes acides, l'acide asiatique, l'acide 2,2-bis(hydroxyméthyl)propionique, l'acide gluconique, le sel de gluconate de sodium, le sel de gluconate de potassium, le sel d'ammonium de gluconate, l'ester méthylique d'acide gluconique, et leurs combinaisons.

8. Composition de polissage mécanique et chimique selon l'une quelconque des revendications précédentes, dans laquelle l'additif chimique est choisi dans le groupe constitué par l'acide gluconique, l'ester méthylique d'acide gluconique, l'ester éthylique d'acide gluconique et leurs combinaisons.

9. Composition de polissage mécanique et chimique selon l'une quelconque des revendications précédentes, dans laquelle la composition comprend des particules de silice colloïdale revêtues d'oxyde de cérium ; l'additif chimique choisi dans le groupe constitué par l'acide gluconique, les sels de gluconate, les esters alkyles d'acide gluconique et leurs combinaisons ; et de l'eau.

10. Composition de polissage mécanique et chimique selon l'une quelconque des revendications précédentes, dans laquelle la composition comprend au moins l'un parmi
de 0,0005 % en poids à 0,025 % en poids du biocide ayant des ingrédients actifs de 5-chloro-2-méthyl-4-isothiazolin-3-one et de 2-méthyl- -isothiazolin-3-one ;
de 0,01 % en poids à 0,5 % en poids d'un agent d'ajustement du pH sélectionné dans le groupe constitué par l'acide nitrique, l'acide chlorhydrique, l'acide sulfurique, l'acide phosphorique, d'autres acides inorganiques ou organiques, et leurs mélanges pour des conditions de pH acide ; ou sélectionné dans le groupe constitué par l'hydrure de sodium, l'hydroxyde de potassium, l'hydroxyde d'ammonium, l'hydroxyde de tétraalkylammonium, les composés de l'hydroxyde d'ammonium quaternaire organique, les amines organiques et leurs combinaisons pour ses conditions de pH alcalin.

11. Procédé de polissage mécanique et chimique (CMP) d'un substrat semi-conducteur ayant au moins une surface comprenant un film d'oxyde de silicium, comprenant
la fourniture du substrat semi-conducteur ;
la fourniture d'un tampon de polissage ;
la fourniture d'une composition de polissage mécanique et chimique (CMP) selon l'une quelconque des revendications 1 à 10 ;
la mise en contact de la surface du substrat semi-conducteur avec le tampon de polissage et la composition de polissage mécanique et chimique ; et
le polissage de l'au moins une surface comprenant du dioxyde de silicium.

12. Système de polissage mécanique et chimique (CMP) d'un substrat semi-conducteur ayant au moins une surface comprenant un film d'oxyde de silicium, comprenant
a. le substrat semi-conducteur ;
b. une composition de polissage mécanique et chimique (CMP) selon l'une quelconque des revendications 1 à 10 ;
c. un tampon de polissage ;
lors de l'utilisation du système, l'au moins une surface comprenant un film d'oxyde de silicium étant en contact avec le tampon de polissage et la composition de polissage mécanique et chimique.

13. Procédé selon la revendication 11 ; dans lequel
le film d'oxyde de silicium est sélectionné dans le groupe constitué par le dépôt chimique en phase vapeur (CVD), le CVD assisté par plasma (PECVD), le CVD par dépôt à haute densité (HDP), ou le film d'oxyde de silicium déposé par centrifugation.

14. Procédé selon la revendication 11 ou 13, dans lequel le substrat semi-conducteur comprend en outre une surface en nitrure de silicium.

15. Procédé selon la revendication 14, dans lequel la sélectivité d'élimination d'oxyde de silicium/nitrure de silicium est supérieure à 25.
